(19) **Europäisches Patentamt / European Patent Office / Office européen des brevets**

(11) **EP 0 795 903 B1**

(12) **FASCICULE DE BREVET EUROPEEN**

(45) Date de publication et mention
de la délivrance du brevet:
**12.03.2008 Bulletin 2008/11**

(51) Int Cl.:
*H01L 21/60* *(2006.01)*  *H01L 23/34* *(2006.01)*
*H01L 21/00* *(2006.01)*

(21) Numéro de dépôt: **97400560.5**

(22) Date de dépôt: **13.03.1997**

(54) **Procédé pour le montage de composants sur un substrat**

Verfahren zur Montage von Bauelementen auf einem Substrat

Method for mounting components on a substrate

(84) Etats contractants désignés:
**CH DE GB LI**

(30) Priorité: **15.03.1996 FR 9603301**

(43) Date de publication de la demande:
**17.09.1997 Bulletin 1997/38**

(73) Titulaire: **COMMISSARIAT A L'ENERGIE ATOMIQUE**
**75015 Paris (FR)**

(72) Inventeurs:
• **Marion, François**
**38120 Saint-Egreve (FR)**

• **Debono, Jean-Marc**
**38100 Grenoble (FR)**
• **Pornin, Jean-Louis**
**38920 Crolles (FR)**
• **Tucek, Bernard**
**38650 Monestier de Clermont (FR)**

(74) Mandataire: **Moutard, Pascal Jean et al**
**Brevalex**
**3, Rue du Docteur Lancereaux**
**75008 Paris (FR)**

(56) Documents cités:
EP-A- 0 668 612    US-A- 4 908 696
US-A- 4 954 453

**Description**

<u>Domaine technique et art antérieur</u>

L'invention se rapporte à la technique d'hybridation "flip-chip".

Il existe deux types principaux de technique permettant la réalisation d'hybridation d'un composant, par exemple une puce, sur un substrat, à l'aide de billes de soudure :

- la première technique est dite de "fusion" : les billes d'un matériau fusible (par exemple en alliage étain-plomb, ou en indium) sont portées à une température égale ou supérieure à leur température de fusion, tout en étant au contact de plots "mouillables", formés sur la puce à connecter,
- la seconde technique est dite technique de "pression" : les billes d'un matériau fusible (alliage étain-plomb, ou indium) sont pressées sur la surface à connecter, et la liaison se fait par thermocompression, au-dessous de la température de fusion des matériaux à connecter.

La présente invention concerne le premier type de technique, c'est-à-dire la technique par fusion.

Deux paramètres sont très importants pour la mise en oeuvre d'une telle technique. Il s'agit :

- du temps de fusion : l'hybridation se caractérise par un cycle de températures au-dessus d'une température $T_{min}$, pendant un certain temps,
- de l'uniformité en température : au moins une puce, ou au moins un composant, est hybridé(e) sur au moins un substrat, et l'uniformité de température du substrat sur l'ensemble du cycle de températures doit rester comprise dans certaines limites, les limites typiquement admises étant de $\pm 2\%$ autour d'une température moyenne du ou des substrats.

Le cycle de températures doit avoir une durée limitée. En effet, un cycle trop long entraîne :

- une diffusion excessive des matériaux de soudure dans les matériaux à souder, c'est-à-dire dans les surfaces mouillables,
- un durcissement des résidus non volatils des flux de soudure employés, rendant leur nettoyage impossible,
- une destruction des composants hybridés ne supportant pas des cycles de températures élevés et longs.

Il est donc important de réduire à une valeur minimum le temps pendant lequel la température est supérieure à la température $T_{min}$.

De manière plus précise, le temps $t_m$ de montée, pour atteindre la température maximum du cycle $T_{max}$, peut être exprimé par :

$$t_m = \frac{C}{\eta w}\left(T_{max} - T_{min}\right)$$

où w est l'énergie électrique appliquée au dispositif de chauffage (en général une source infrarouge), et où est une constante exprimant le rendement du transfert d'énergie entre l'énergie appliquée à la source de chauffage, et l'énergie calorifique récupérée par la sole chauffante. C est la capacité calorifique de l'ensemble constitué par la sole chauffante, le substrat et les puces à hybrider.

Si un temps de montée court est exigé, il est donc nécessaire de disposer d'une faible capacité calorifique C, d'une énergie w importante, et d'une constante $\eta$ élevée.

Par ailleurs, le temps de descente est proportionnel à l'énergie emmagasinée dans la sole chauffée, et inversement proportionnel à la puissance de refroidissement des moyens de refroidissement de la sole (par exemple de l'air forcé injecté).

A tout instant t, si $T_{m(t)}$ et $T_{M(t)}$ désignent respectivement la température minimum spatiale et la température maximum spatiale de la sole, l'uniformité de température est mesurée par :

$$U = \frac{T_{M(t)} - T_{m(t)}}{T_{M(t)} + T_{m(t)}}.$$

La source de chauffage est en général une source infrarouge constituée de rampes de lampes émettant chacune une radiation ponctuelle et non uniforme. L'uniformité de la sole ne peut être rétablie que par une répartition par conduction thermique, dans le plan de la sole, de l'énergie absorbée. Or, la conduction latérale dans la sole est proportionnelle à l'épaisseur de la sole. L'uniformité U étant inversement proportionnelle à l'épaisseur de la sole, ainsi qu'à la conduction latérale, une bonne uniformité requiert donc une forte épaisseur de la sole, et une forte capacité calorifique C. Ainsi qu'il a été expliqué ci-dessus, une forte capacité calorifique entraîne un temps de montée long et, par conséquent, un cycle de températures long.

Si, par exemple, une très bonne uniformité, de l'ordre de 2%, est requise, ceci se traduit par :

$$U < 2\% \Rightarrow C > C_0,$$

et si un temps de montée maximum $t_0$ est imposé, alors :

$$t_m < t_0 \Rightarrow W > \frac{C_0(T_{max} - T_{min})}{\eta t_0}.$$

Par conséquent, pour avoir à la fois une bonne uniformité et un temps de montée minimum, il est nécessaire d'augmenter la puissance de chauffage. A son tour, une puissance de chauffage élevée a pour conséquence des pertes thermiques accrues, toute la puissance perdue contribuant à chauffer le reste de la machine, qui est une machine de précision en alignement. Il faut donc prévoir des moyens de refroidissement pour évacuer l'énergie emmagasinée dans la sole, mais aussi l'énergie résiduelle distribuée dans le reste de la machine, d'où une complication importante de celle-ci, et un surcoût important dans sa fabrication. De plus, les méthodes de refroidissement de la sole par convection sont insuffisantes, et celle-ci doit être refroidie par fluide, ce qui entraîne encore un autre surcoût de la machine.

Enfin, lorsqu'une puissance de chauffage importante est mise en jeu, la sole chauffante voit, après coupure du dispositif ou des lampes de chauffage, sa température continuer à croître par inertie, et il en résulte que les températures au pic sont peu reproductibles (on constate typiquement une reproductibilité ≥2%).

Selon un exemple de réalisation d'un procédé selon l'art antérieur, on réalise la multihybridation de puces sur un substrat silicium de diamètre 150 mm, d'épaisseur 600 µm, l'hybridation devant se faire :

- avec un cycle d'une durée $t_m$ inférieure à 40 secondes, $T_{min}$ et $T_{max}$ étant respectivement égaux à 150°C et à 320°C,
- et une uniformité de température de 5% au cours du cycle.

Ces spécifications entraînent un dimensionnement de la sole chauffée, conduisant à une puissance électrique de commande des lampes de 4500 watts.

Exposé de l'invention

L'invention a pour objet d'améliorer la technique de fusion, de façon à réduire le temps de réalisation de la soudure, donc la durée du cycle de température auquel le composant et le substrat à hybrider sont soumis, et de manière à améliorer l'uniformité de température de la soudure sur les composants hybridés, et plus spécialement dans les cas dits de multihybridation. Enfin, il est nécessaire de réduire le coût et la complexité de fabrication des machines d'hybridation, en conservant ou en améliorant les spécifications techniques sur les cycles de températures de soudure.

De manière plus précise, l'invention a pour objet un procédé d'hybridation de composants par billes de soudure, sur un substrat porté à une température sensiblement uniforme par mise en contact thermique du substrat avec un élément chauffant d'un four placé sous le substrat, caractérisé en ce qu'il comprend :

- la montée en température de l'élément chauffant du four, sans contact, ni avec le substrat ni avec le composant à hybrider, jusqu'à une température apte à réaliser la fusion des billes de soudure,
- la préparation d'un ensemble constitué par le substrat, les billes de soudure et le composant à hybrider,
- la mise en contact thermique du substrat ainsi préparé avec l'élément chauffant pendant un temps Δt de façon que la température sensiblement uniforme à laquelle est portée le substrat permette la fusion des billes de soudure,

le découplage du substrat et de l'élément chauffant, à la fin de l'intervalle de temps Δt.

Ce procédé permet d'éviter que le substrat soit solidaire de l'élément chauffant du four, pendant la montée en température. Le temps de contact est bien défini, et il est possible de réaliser une hybridation en un temps de contact faible, typiquement moins de 10 secondes. Ce procédé est donc particulièrement intéressant pour les composants très sensibles aux excursions en température.

En outre, avant de mettre le substrat en contact thermique avec l'élément chauffant, il est possible d'atteindre une bonne uniformité de ce dernier.

Le contact entre le substrat et l'élément chauffant peut être réalisé à un moment où ce dernier ne voit plus sa température croître, et une reproductibilité améliorée des pics est donc obtenue.

Enfin, le système de refroidissement de l'élément chauffant et du four n'est plus critique.

Les moyens de chauffage à mettre en oeuvre pour l'élément chauffant n'ont pas besoin d'être aussi puissants que dans les dispositifs de l'art antérieur, puisque le procédé selon l'invention permet de concilier les contraintes relatives d'une part à la durée du cycle de températures, d'autre part à l'uniformité de la température.

La mise en contact thermique du substrat peut avoir lieu par abaissement de celui-ci sur l'élément chauffant. Ce type de mouvement limite les causes de désalignement du composant par rapport au substrat.

De plus, le substrat et le composant à hybrider peuvent reposer sur une sole mobile, la mise en contact de cette sole mobile avec l'élément chauffant assurant la mise en contact thermique du substrat et de l'élément chauffant.

Ainsi on peut contrôler les rampes de montée en température du substrat (la capacité calorifique de la sole mobile étant connue).

L'utilisation d'une sole mobile permet d'y déposer des substrats de tailles différentes.

Ce procédé peut comporter en outre les étapes préalables suivantes :

- le positionnement du substrat sur l'élément chauffant, ou sur une sole mobile reposant sur l'élément chauffant, ce dernier étant maintenu à une température inférieure à la température de fusion des billes de soudure,
- l'alignement du composant à hybrider sur le substrat,
- le découplage, d'une part de l'ensemble formé par le composant à hybrider, le substrat et éventuellement par la sole mobile, et d'autre part de l'élément chauffant, avant la montée en température de celui-ci.

Dans ce cas, le positionnement et l'alignement du substrat et du composant ont lieu sur l'élément chauffant lui-même.

Le découplage de l'ensemble constitué par le composant, le substrat et éventuellement la sole mobile, peut être réalisé par un soulèvement à partir de l'élément chauffant.

Là encore, un tel mouvement permet de limiter les causes de désalignement.

Il est possible de réaliser l'étape préalable d'alignement du composant en une première station, dite d'alignement, puis l'étape préalable de découplage en une seconde station, dite station de découplage, l'élément chauffant étant déplacé de la première station à la seconde station entre les deux étapes préalables d'alignement et de découplage.

Ainsi, l'ensemble constitué par le substrat et le composant n'est, après alignement, soumis qu'à un mouvement vertical par rapport à l'élément chauffant, et c'est ce dernier qui est déplacé entre les deux stations. Par conséquent, les mouvements du substrat sont d'ampleur limitée et évitent les problèmes de heurts, de vibrations ou de désalignement du composant par rapport au substrat qui se présenteraient si ce dernier était déplacé par rapport à l'élément chauffant.

Selon un autre mode de réalisation, le positionnement du substrat a lieu sur un support qui est lui-même sans contact avec l'élément chauffant ; puis, le composant à hybrider est aligné sur le substrat. Le procédé ne nécessite alors aucun dispositif de refroidissement de l'élément chauffant, puisqu'il n'y a contact thermique entre cet élément et l'ensemble substrat-composant qu'après alignement du composant par rapport au substrat.

Une étape de soulèvement du substrat, du composant à hybrider et, éventuellement, de la sole mobile peut en outre être prévue.

Cette étape peut avoir lieu après transport de l'ensemble vers une station de soulèvement et d'abaissement.

Dans le cadre de ce second mode de réalisation, la mise en contact thermique du substrat avec l'élément chauffant peut avoir lieu par déplacement de l'élément chauffant vers la station de soulèvement et d'abaissement, puis abaissement de l'ensemble constitué par le composant et le substrat et éventuellement, la sole mobile, après montée en température de l'élément chauffant.

Ainsi, là encore, seuls des déplacements verticaux du substrat et du composant sont mis en jeu, par déplacement ou soulèvement, ce qui limite les problèmes de désalignement lors d'un déplacement du substrat par rapport à l'élément chauffant.

Quel que soit le mode de réalisation, les mouvement de soulèvement et/ou d'abaissement peuvent être réalisés à l'aide d'une cloche à l'intérieur de laquelle une atmosphère contrôlée est établie.

De plus, après fusion du matériau constitutif des billes d'hybridation puis découplage de substrat et de l'élément chauffant, une étape de refroidissement du substrat peut être réalisée, par exemple par contact du substrat ou de la sole mobile, avec une surface de refroidissement.

Un dispositif d'hybridation de composants par billes de soudure sur un substrat porté à une température sensiblement uniforme par mise en contact thermique du substrat avec un élément chauffant d'un four placé sous le substrat, qui n'est pas revendiqué est décrit ci-après:

- des moyens de chauffage équipés de capteurs thermiques pour chauffer l'élément chauffant du four, sans contact, ni avec le substrat, ni avec le composant à hybrider, jusqu'à une température sensiblement uniforme apte à réaliser la fusion des billes de soudure, les capteurs thermiques permettant de contrôler la température et l'uniformité thermique de l'élément chauffant,
- des moyens pour amener le substrat équipé de billes de soudure et du composant à hybrider en contact thermique avec l'élément chauffant, de façon que la température sensiblement uniforme à laquelle est portée le substrat permette la fusion des billes de soudure,
- des moyens pour découpler le substrat de l'élément chauffant, après chauffage du substrat.

Ce dispositif permet de mettre en oeuvre le procédé selon l'invention, avec les avantages liés à ce dernier.

Les moyens pour amener le substrat en contact avec l'élément chauffant (et/ou les moyens pour découpler le substrat de l'élément chauffant) peuvent être du type permettant un mouvement vertical, par exemple une cloche et des moyens pour établir une atmosphère contrôlée sous ladite cloche.

En outre, des moyens peuvent être prévus pour déplacer l'élément chauffant dans un plan, par exemple un chariot mobile sur lequel cet élément chauffant est monté. Ainsi, c'est l'élément chauffant qui est déplacé latéralement, ce qui réduit les déplacements du substrat par rapport à l'élément chauffant et limite donc les risques de désalignement au cours du déroulement du procédé.

Le dispositif peut en outre comporter un support sur lequel un substrat peut être positionné sans contact avec l'élément chauffant.

Dans tous les cas, des moyens de refroidissement du substrat peuvent en outre être prévus, par exemple des moyens comportant une plaque de refroidissement.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1 illustre un premier mode de réalisation d'un procédé selon l'invention,
- les figures 2A à 2C représentent des étapes préliminaires d'un procédé selon l'invention,
- la figure 3 représente une variante pour le déplacement d'un substrat par rapport à l'élément de chauffage, dans le cadre d'un procédé selon l'invention,
- la figure 4 représente une variante de l'invention,
- les figures 5A à 5E représentent des étapes de mise en oeuvre d'un autre mode de réalisation,
- les figures 6A à 6D représentent des étapes de mise en oeuvre d'un autre mode de réalisation de l'invention.

Description détaillée de modes de réalisation de l'invention

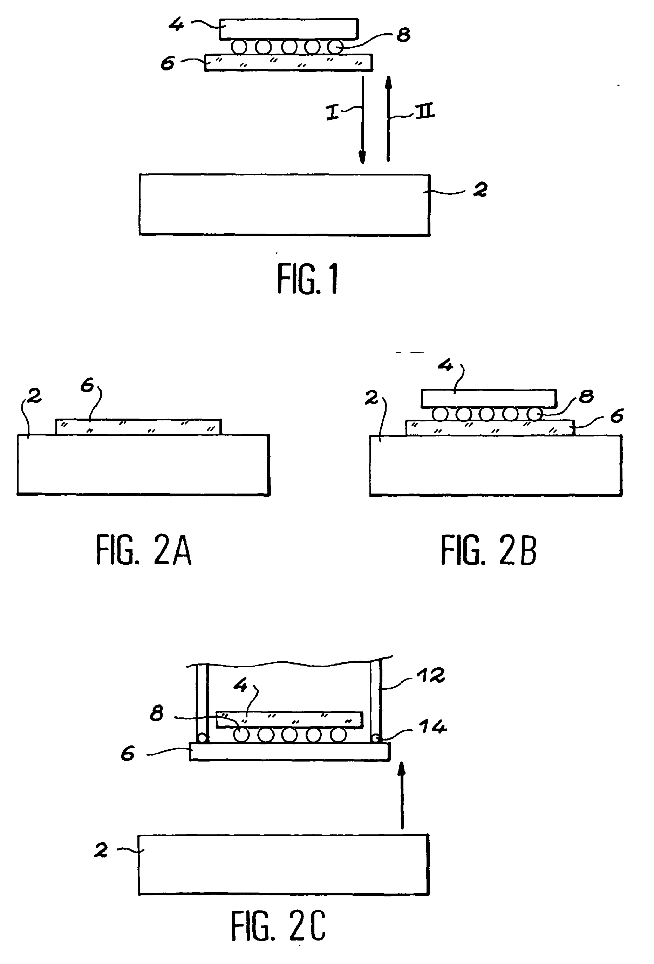

Un premier mode de réalisation va être décrit en liaison avec la figure 1. Sur cette figure, la référence 2 désigne la sole d'un four dont les autres parties, en particulier les moyens de chauffage, ne sont pas représentés. Ces moyens peuvent être du type résistances de chauffage ou caloduc, moins puissants que les moyens (du type lampes I.R.) mis en oeuvre dans les dispositifs de l'art antérieur. Un composant 4 est à hybrider sur un substrat 6 à l'aide de microbilles 8, telles que par exemple des billes d'étain-plomb ou d'indium. La température de fusion minimum à atteindre dépend de la nature de ces microbilles 8.

Le composant 4 et le substrat 6 munis de billes sont préalablement alignés l'un par rapport à l'autre, puis mis en contact l'un avec l'autre.

Avant de mettre en contact le substrat 6 avec la sole 2, cette dernière subit une montée en température, jusqu'à une température permettant de réaliser la fusion des billes 8. La température et l'uniformité thermique de la sole 2 peuvent être contrôlées à l'aide de capteurs thermiques (par exemple : sondes en platine ou thermocouples) disposés sur la sole. Après montée en température de la sole 2, le substrat 6 et le composant 4 sont mis en contact thermique avec la sole 2 : cette mise en contact est symbolisée sur la figure 1 par la flèche I. Le contact est maintenu pendant un certain temps $\Delta t$. Ce temps est par exemple déterminé expérimentalement, comme le temps le plus court nécessaire pour sonder toutes les billes de liaison sur les surfaces mouillables en regard du composant 4.

Après écoulement du temps $\Delta t$, l'ensemble constitué par le substrat 6 et le composant 4 sont découplés de la sole 2 : ce découplage est symbolisé par la flèche II sur la figure 1.

Préalablement, l'ensemble substrat 6 + composant 4 peut avoir été préparé sur la sole 2, celle-ci étant maintenue à température ambiante ou, au moins, à une température inférieure à la température minimum de fusion des billes 8. Ainsi, dans une première étape préalable (figure 2A) le substrat 6 muni des billes est déposé sur la sole 2 ; le composant 4 est aligné, la sole 2 étant toujours maintenue à la température précédente (figure 2B). Enfin, dans une troisième étape préalable, l'ensemble constitué par le substrat 6 et le composant 4 est éloigné, ou découplé, de la sole 2, avant montée en température de cette dernière (figure 2C). La montée en température a ensuite lieu, puis les étapes décrites ci-dessus en liaison avec la figure 1 sont réalisées.

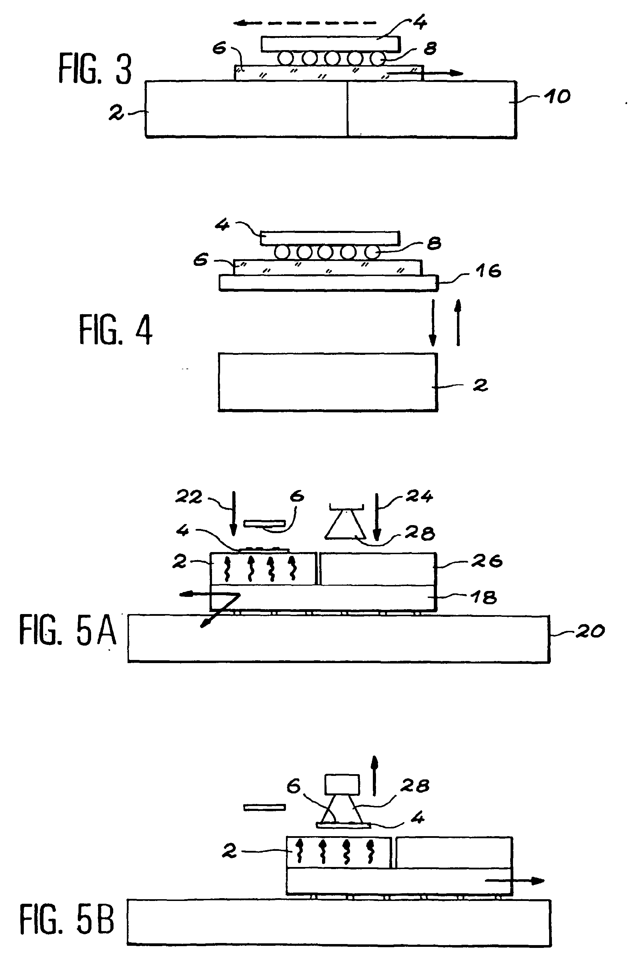

La mise en contact thermique du substrat avec la sole, et le découplage du substrat et de la sole ont de préférence lieu par soulèvement ou abaissement de l'ensemble substrat-composant par rapport à la sole 2. Selon un autre mode de mise en oeuvre, illustré sur la figure 3, on réalise un déplacement latéral du substrat 6 par rapport à la sole 2. Ainsi, après alignement, le substrat est amené sur un support 10, découplé thermiquement de la sole 2. Il y a ensuite montée en température de cette dernière, puis déplacement de l'ensemble formé par le substrat 6 et le composant 4, depuis le support 10 vers la sole 2 (flèche en traits interrompus sur la figure 3). Ce type de déplacement est possible, mais il peut présenter plus de problèmes de heurts, de vibrations ou de désalignement de l'ensemble composant-substrat que dans le cas d'un déplacement suivant un axe vertical, qui n'a besoin que d'une amplitude de l'ordre de quelques millimètres au plus. Un tel déplacement, suivant un axe vertical, peut être réalisé à l'aide d'une cloche venant en contact avec le substrat 6, et à l'intérieur de laquelle une atmosphère contrôlée peut être réalisée. Ainsi, sur la figure 2C, la référence 12 désigne la partie inférieure de la paroi d'une cloche à atmosphère contrôlée; les moyens pour établir une atmosphère contrôlée à l'intérieur de la cloche ne sont pas représentés sur cette figure. Le maintien étanche du substrat 6, contre l'extrémité de la paroi 12 est réalisé par dépression ménagée en plusieurs points sur la périphérie 14 du substrat. Lorsque le substrat 6 est en position de contact avec la sole 2, qui a été préchauffée, au-dessus de la température de fusion de la soudure, l'atmosphère contrôlée est maintenue à l'intérieur de la cloche, de manière à permettre une soudure des billes du substrat 6 sur les surfaces mouillables du composant 4.

Le procédé selon l'invention propose de ne coupler le substrat et l'élément de chauffage du four que lorsque ce dernier a atteint une température et une uniformité en température suffisantes.

Des moyens pour refroidir l'élément chauffant peuvent être prévus, du type soufflage ou circulation de fluide caloporteur. Mais ces moyens, si ils sont présents, sont réduits par rapport à ceux mis en oeuvre dans le cas d'un dispositif de l'art antérieur. Dans certains cas, ils peuvent même être supprimés, en particulier lorsque, comme décrit ci-dessous, l'alignement substrat-composant n'est pas réalisé sur l'élément chauffant 2. Quant aux parties de l'appareil sensibles aux dilatations thermiques (dispositifs optiques, par exemple pour l'alignement), leur système de régulation en température n'est plus nécessaire. En effet, le substrat n'est mis en contact avec l'élément chauffant qu'après montée en température de celui-ci. Toute étape d'alignement et/ou de contrôle optique a donc lieu avant que le substrat et le composant ne soient en contact thermique avec un élément dont la température est élevée.

Selon une variante illustrée sur la figure 4, le substrat 6 et le composé 4 sont d'abord préalablement déposés sur un support 16, par exemple une sole sur laquelle l'alignement est réalisé. C'est cette sole qui est déplacée, que ce soit selon un axe vertical, comme illustré sur la figure 4, par exemple à l'aide d'une cloche à vide, ou dans le plan de la sole 2, comme décrit ci-dessus en liaison avec la figure 3. On transporte donc la sole 16 au lieu de transporter le substrat 6. L'épaisseur de la sole 16 détermine sa capacité calorifique et permet de contrôler la montée en température du substrat 6 et du composant 4, lorsqu'elle est mise en contact avec la sole 2 préalablement chauffée. En outre, l'utilisation d'un support mobile ou d'une sole mobile 16 permet de transporter et/ou de déplacer des substrats 6 de tailles différentes.

Un autre mode de réalisation va être décrit en liaison avec les figures 5A à 5E. Sur ces figures, la référence 2 désigne encore un élément de chauffage, ou une sole, d'un four. Cet élément chauffant ou sole repose sur des moyens 18, tels qu'un chariot mobile, pouvant se déplacer par rapport à un bâti fixe 20. Ainsi, l'élément chauffant 2 peut être déplacé entre une première station 22 dite d'alignement, et une seconde station 24, dite de découplage. A l'endroit de cette station 24, sont disposés des moyens 28, tels que par exemple une cloche à atmosphère contrôlée, permettant de réaliser un déplacement suivant un axe vertical, vers le haut ou vers le bas, d'un substrat et d'un composant.

Le substrat 4 est préalablement déposé sur l'élément chauffant 2, qui est amené dans la zone d'alignement 22. Là, un composant 6 est aligné par rapport au substrat 4 muni de billes, avec des moyens connus par ailleurs de l'homme de l'art. Puis le composant 6 est déposé sur le substrat 4.

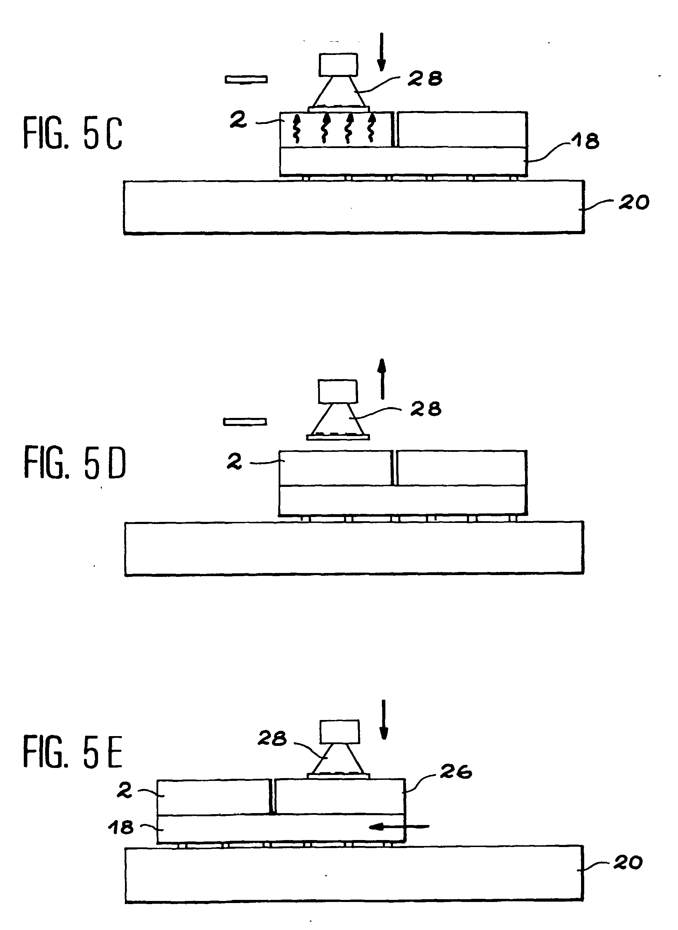

L'élément de chauffage 2 est ensuite déplacé en direction de la station de découplage 24 (figure 5B), où la cloche à atmosphère contrôlée 28 vient prélever l'ensemble substrat-composant, avant montée en température de l'élément de chauffage 2. Puis (figure 5C), après montée en température et stabilisation, l'ensemble substrat-composant est descendu en contact thermique avec la sole 2, afin de réaliser la fusion des microbilles. L'atmosphère contrôlée à l'intérieur du dispositif 28 n'est pas rompu ni modifié.

Après fusion et soudure des billes, l'ensemble composant-substrat est ramené en position haute par le dispositif 28 (figure 5D) . L'ensemble composant-substrat peut ainsi être maintenu, jusqu'à refroidissement du métal d'hybridation, ou bien il peut être transporté en direction d'une zone de refroidissement. Pendant ce temps, la sole 2 peut être ramenée par le chariot mobile 18 en direction d'une zone de chargement d'un autre substrat, qui sera ensuite amené vers la zone de positionnement et d'alignement 22 pour recevoir un autre composant 6. Selon une variante, une plaque de refroidissement 26 est disposée à côté de la sole 2 sur le chariot mobile 18, et, après découplage du substrat 4 et de la sole 2 (figure 5D) l'ensemble sole-plaque de refroidissement est déplacé par le chariot 18 de manière à amener la plaque de refroidissement 26 en face de la station 24. Là, le substrat 4 peut être ramené en contact avec la plaque de refroidissement 26 (figure 5E).

Toutes les étapes décrites ci-dessus en liaison avec les figures 5A à 5E peuvent également être réalisées avec un substrat 4 déposé sur une sole mobile 16, comme illustré sur la figure 4. C'est alors la sole mobile qui est transportée, pour déplacer le substrat et le composant.

L'utilisation d'un chariot mobile 18 pour déplacer le four 2 et, éventuellement, la plaque de refroidissement 26 permet de ne mettre en oeuvre que des mouvements du substrat et du composant d'amplitude limitée : ces mouvements consistent en un déplacement de quelques millimètres ou de quelques micromètres, suivant un axe vertical, et tous les mouvements latéraux sont réalisés par le chariot mobile.

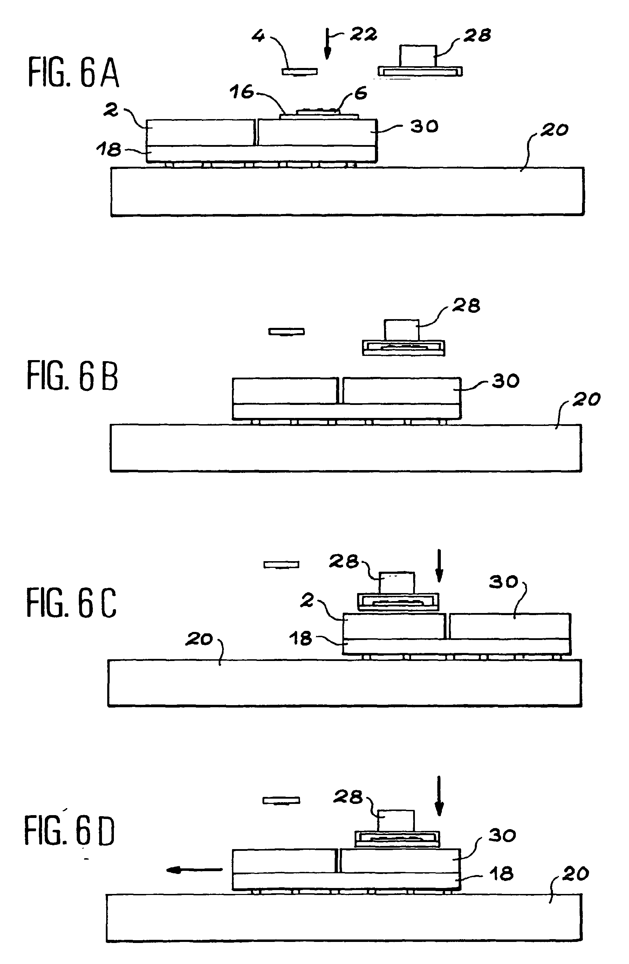

Un autre mode de réalisation va être décrit en liaison avec la figure 6A à 6D. Sur ces figures, la sole 2 est montée sur un chariot mobile 18 par rapport à un substrat fixe 20. A côté de la sole 2 est positionné, également sur le chariot mobile, un support de chargement et d'alignement 30.

Un substrat 6 (ou une sole mobile 16) sont préalablement disposés sur le support 30. Le chariot est ensuite déplacé de manière à amener ce support dans une zone de positionnement 22, et un composant 4 y est positionné par rapport au substrat 6 (figure 6A). Il y a ensuite déplacement du chariot de manière à diriger l'ensemble formé par le composant 4, le substrat 6 et, éventuellement, la sole intermédiaire 16, en face de la cloche à vide 28. Celle-ci est descendue, prélève l'ensemble composant-substrat-sole et amène cet ensemble en position haute (figure 6B). Simultanément, la sole 2 est montée en température et, après uniformisation de la température, la sole 2 est amenée sous la cloche 28 pour que celle-ci puisse y déposer l'ensemble composant-substrat-sole intermédiaire (figure 6C). Cet ensemble subit alors le cycle de fusion. A l'issue de ce cycle, la cloche ramène le composant, le substrat et la sole en position haute, et la sole de chauffage 2 est éloignée à l'aide du chariot mobile 18. La cloche 28 peut être ramenée en position basse sur le support 30 pour y déposer l'ensemble composant-substrat-sole intermédiaire. Le support 28 peut être un support ou une plaque de refroidissement.

Là encore, les mouvements du substrat et du composant sont limités à des mouvements suivant l'axe vertical, et l'amplitude de l'ordre de quelques millimètres ou de quelques micromètres, les mouvements de déplacement latéraux étant réalisés par le chariot mobile 18.

Dans tous les modes de réalisation décrits ci-dessus, la cloche 28 peut être reliée à une articulation souple ou réglable, qui permet de compenser des défauts de parallélisme entre la surface inférieure de la cloche et le substrat 6 ou la sole intermédiaire 16 avec lequel cette surface inférieure est amenée en contact.

[0067] - Toutes les opérations des divers modes de réalisation décrits ci-dessus peuvent être pilotées par un micro-ordinateur, qui collecte les données de température, de positionnement et d'alignement, et qui détermine l'avance des moyens de déplacement tels que le chariot mobile 18, la montée ou la descente de la cloche 28, ainsi que la mise sous atmosphère contrôlée de l'intérieur de la cloche. Comme il apparaîtra à l'homme du métier, les différentes étapes peuvent être programmées sur un micro-ordinateur classique, les instructions de programme appropriées étant mémorisées sur des disques magnétiques ou sur des unités RAM ou ROM conventionnelles.

Quel que soit le mode de réalisation choisi, le procédé selon l'invention permet de réduire les durées de contact entre le substrat et la sole de chauffage, et il permet d'obtenir de très bonnes uniformités sur de grandes surfaces, même pour des substrats de diamètre supérieur à 200 mm.

Par ailleurs, le dispositif employé pour réaliser ce procédé voit son coût de fabrication singulièrement réduit, puisqu'il est possible de diminuer la puissance des alimentations, de réduire les systèmes de refroidissement du four, de supprimer les systèmes de régulation en température des parties sensibles aux dilatations thermiques (telles que les parties optiques, ou les dispositifs pour l'alignement) et qu'il est possible de modifier le dispositif de mise en température du four pour adapter des systèmes moins coûteux, plus uniformes, plus simples mais de plus grande inertie. La possibilité de réaliser l'opération d'alignement avec le substrat posé sur la table de refroidissement permet d'obtenir une table d'alignement simple et facile à régler et de maintenir éventuellement le four à température constante en permanence, ce qui augmente la productivité de la machine.

**Revendications**

1. Procédé d'hybridation de composants (4) par billes (8) de soudure, sur un substrat (6) porté à une température sensiblement uniforme par mise en contact thermique du substrat (6) avec un élément chauffant (2) d'un four placé sous le substrat, **caractérisé en ce qu'**il comprend :

- la montée en température de l'élément chauffant (2) du four, sans contact, ni avec le substrat ni avec le composant à hybrider, jusqu'à une température apte à réaliser la fusion des billes (8) de soudure,
- la préparation d'un ensemble constitué par le substrat (6), les billes (8) de soudure et le composant à hybrider,
- la mise en contact thermique du substrat (6) ainsi préparé avec l'élément chauffant (2) pendant un temps Δt de façon que la température sensiblement uniforme à laquelle est portée le substrat permette la fusion des billes de soudure,

le découplage du substrat (6) et de l'élément chauffant (2), à la fin de l'intervalle de temps Δt.

2. Procédé selon la revendication 1, la mise en contact thermique du substrat (6) ayant lieu par abaissement de celui-ci sur l'élément chauffant (2).

3. Procédé selon l'une des revendications 1 ou 2, le substrat et le composant à hybrider reposant sur une sole mobile (16), la mise en contact de cette sole mobile avec l'élément chauffant assurant la mise en contact thermique du substrat et de l'élément chauffant.

4. Procédé selon l'une des revendications 1 à 3, comportant les étapes préalables suivantes :

- le positionnement du substrat (6) sur l'élément chauffant (2) ou sur une sole mobile (16) reposant sur l'élément chauffant, ce dernier étant maintenu à une température inférieure à la température de fusion des billes de soudure (8),
- l'alignement du composant (4) à hybrider sur le substrat (6),
- le découplage, d'une part de l'ensemble formé par le composant à hybrider (4), le substrat (6) et, éventuellement, par la sole mobile, et, d'autre part de l'élément chauffant (2), avant la montée en température de celui-ci.

5. Procédé selon la revendication 4, l'étape préalable de découplage de l'ensemble formé par le composant (4), le substrat (6) et, éventuellement la sole mobile ayant lieu par un soulèvement du substrat (6), du composant (4) et, éventuellement, de la sole mobile (16), à partir de l'élément chauffant (2).

6. Procédé selon l'une des revendications 4 ou 5, l'étape préalable d'alignement du composant (4) à hybrider sur le substrat (6) ayant lieu en une première station (22), dite d'alignement, l'étape préalable de découplage ayant lieu en une seconde station (24), dite de découplage, et l'élément chauffant (2) étant déplacé de la première station (22) à la seconde station (24), entre les deux étapes préalables d'alignement et de découplage.

7. Procédé selon l'une des revendications 1 à 3, comportant les étapes préalables suivantes :

- le positionnement du substrat (6) sur un support (16, 30), lui-même sans contact avec l'élément chauffant (2),
- l'alignement du composant à hybrider sur le substrat.

8. Procédé selon la revendication 7, comportant en outre une étape de soulèvement du substrat (6), du composant (4) à hybrider et, éventuellement, de la sole mobile (16).

9. Procédé selon la revendication 8, l'étape de soulèvement du substrat et du composant et, éventuellement, de la sole, ayant lieu après transport de l'ensemble constitué par le substrat, le composant à hybrider et, éventuellement, la sole mobile, vers une station (24) de soulèvement et d'abaissement.

10. Procédé selon la revendication 9, la mise en contact thermique du substrat (6) avec l'élément chauffant (2) ayant lieu par déplacement de l'élément chauffant (2) vers la station de soulèvement et d'abaissement, et abaissement de l'ensemble formé par le composant, le substrat, et, éventuellement, la sole mobile (16), après montée en température de l'élément chauffant (2).

11. Procédé selon l'une des revendications 2, 5, 8, 9 ou 10, le soulèvement et/ou l'abaissement étant réalisé(s) à l'aide d'une cloche (28) à l'intérieur de laquelle une atmosphère contrôlée est établie.

12. Procédé selon l'une des revendications précédentes, comportant, après découplage du substrat (6) et de l'élément chauffant (2), une étape de refroidissement du substrat.

13. Procédé selon la revendication 12, le refroidissement ayant lieu par contact du substrat (6), ou de la sole mobile (16), avec une surface (30) de refroidissement.

**14.** Procédé selon les revendications 7 et 13, le support sur lequel le substrat est positionné étant constitué par la surface de refroidissement.

**Claims**

**1.** Method for the hybridization of chip components (4) by solder beads (8), on a substrate (6) raised to a substantially uniform temperature by the thermal contacting of the substrate (6) with a heating element (2) of an oven placed beneath the substrate, **characterized in that** it comprises:

- the raising of the temperature of the heating element (2) of the oven without contact either with the substrate or with the component to be hybridized until a temperature is reached which is suitable for the fusion of the solder beads (8),
- the preparation of an assembly constituted by the substrate (6), the solder beads (8) and the component to be hybridized,
- the thermal contacting of the thus prepared substrate (6) with the heating element (2) for a time Δt so that the substantially uniform temperature to which the substrate is raised permits the fusion of the solder beads,
- uncoupling the substrate (6) and the heating element (2) at the end of the time interval Δt.

**2.** Method in accordance with claim 1, the substrate (6) being brought into thermal contact by lowering said substrate onto the heating element (2).

**3.** Method in accordance with either of claims 1 or 2, the substrate and the component to be hybridized resting on a mobile heating-plate (16), the contact made between said mobile heating-plate with the heating element providing thermal contact between the substrate and the heating element.

**4.** Method according to one of the claims 1 to 3, comprising the following prior stages:

- positioning substrate (6) on heating element (2) or on a mobile heating plate (16) resting on the heating element, the latter being kept at a temperature below the melting point of the solder beads (8), alignment of component (4) to be hybridized with substrate (6),
- uncoupling of on the one hand the assembly formed by the component to be hybridized (4), substrate (6) and optionally the mobile heating plate and on the other the heating element (2) prior to the temperature rise of the latter.

**5.** Method in accordance with claim 4, the preliminary stage of uncoupling the unit made up of the component (4), the substrate (6) and possibly the mobile heating plate being made by lifting the substrate (6), the component (4) and possibly the mobile heating element (16) off the heating element (2).

**6.** Method in accordance with either of claims 4 or 5, the preliminary stage of aligning the component (4) to be hybridized on the substrate (6) taking place at a first so-called aligning station (22), the preliminary stage of uncoupling taking place at a second so-called uncoupling station (24), and the heating element (2) being moved from the first station (22) to the second station (24) between the two preliminary stages of alignment and uncoupling.

**7.** Method according to one of the claims 1 to 3, comprising the following preliminary stages:

- positioning substrate (6) on a support (16, 30), itself without contact with heating element (2),
- the alignment of the component to be hybridized with the substrate.

**8.** Method according to claim 7, also comprising a stage of raising the substrate (6), the component (4) to be hybridized and optionally the mobile heating plate (16).

**9.** Method in accordance with claim 8, the lifting stage of the substrate and component taking place after transferring the unit made up of the substrate, the component to be hybridized and optionally the mobile heating plate towards a lifting and lowering station (24).

**10.** Method in accordance with claim 9, the substrate (6) being brought into thermal contact with the heating element (2) by moving the heating element (2) towards the lifting and lowering station, and lowering the unit made up of the component, the substrate and optionally the mobile heating plate (16) after the temperature of the heating element (2) has been raised.

**11.** Method in accordance with one of the claims 2, 5, 8, 9 or 10, the lowering and/or lifting being made by means of a bell-jar (28) inside which a controlled atmosphere has been established.

**12.** Method in accordance with any of the preceding claims, comprising after uncoupling the substrate (6) and the heating element (2), a substrate cooling stage.

**13.** Method in accordance with claim 12, cooling taking place by contact of the substrate (6), or the mobile heating plate (16), with a cooling surface (30).

**14.** Method in accordance with claims 7 and 13, the support on which the substrate is positioned consisting of the cooling surface.

**Patentansprüche**

**1.** Verfahren zur Hybridierung von Bauteilen (4) mittels Lotkugeln (8) auf einem Substrat (6), das auf eine im Wesentlichen gleichmäßige Temperatur gebracht wird durch die Herstellung eines thermischen Kontakts des Substrats (6) mit einem Heizelement (2) eines unter dem Substrat angeordneten Ofens,
**dadurch gekennzeichnet, dass** es umfasst:

- den Temperaturanstieg des Heizelements (2) des Ofens ohne Kontakt, weder mit dem Substrat noch mit dem zu hybridierenden Bauteil, bis auf eine der Schmelztemperatur der Lotkugeln (8) entsprechende Temperatur,
- die Präparierung eines aus dem Substrat (6), den Lotkugeln (8) und dem zu hybridierenden Bauteil bestehenden Ganzen,
- die Herstellung des Kontakts des so präparierten Substrats (6) mit dem Heizelement (2) während einer Zeit $\Delta t$, so dass die im Wesentlichen gleichmäßige Temperatur, auf die das Substrat gebracht wird, das Schmelzen der Lotkugeln ermöglicht.

die Entkopplung des Substrats (6) und des Heizelements (2) am Ende des Zeitintervalls $\Delta t$.

**2.** Verfahren nach Anspruch 1, wobei die Herstellung des Kontakts des Substrats (6) stattfindet, indem man dieses auf das Heizelement (2) absenkt.

**3.** Verfahren nach einem der Ansprüche 1 oder 2, wobei das Substrat und das zu hybridierende Bauteil sich auf einem beweglichen Träger (16) befinden und die Herstellung des Kontakts dieses Trägers mit dem Heizelement die Herstellung eines thermischen Kontakts zwischen dem Substrat und dem Heizelement gewährleistet.

**4.** Verfahren nach einem der Ansprüche 1 bis 3 mit den folgenden Vorausschritten:

- Positionierung des Substrats (6) auf dem Heizelement (2) oder auf einem auf dem Heizelement ruhenden beweglichen Träger (16), wobei dieses auf einer Temperatur gehalten wird, die niedriger ist als die Schmelztemperatur der Lotkugeln (8),
- Ausrichtung des zu hybridierenden Bauteils (4) auf dem Substrat (6),
- Entkopplung von einerseits dem durch das zu hybridierende Bauteil (4), das Substrat (6) und eventuell dem beweglichen Träger gebildeten Ganzen und andererseits dem Heizelement vor dessen Temperaturanstieg.

**5.** Verfahren nach Anspruch 4, wobei der Vorausschritt zur Entkopplung des durch das zu hybridierende Bauteil (4), das Substrat (6) und eventuell den beweglichen Träger gebildeten Ganzen darin besteht, das Substrat (6), das Bauteils (4) und eventuell den beweglichen Träger (16) von dem Heizelement (2) abzuheben bzw. hochzuheben.

**6.** Verfahren nach einem der Ansprüche 4 oder 5, wobei der Vorausschritt zur Ausrichtung des auf das Substrat (6) zu hybridierenden Bauteils (4) in einer ersten Station (22) stattfindet, Ausrichtstation genannt, der Vorausschritt zur Entkopplung in einer zweiten Station (24) stattfindet, Entkopplungsstation genannt, und das Heizelement (2) zwischen den beiden Vorausschritten, jeweils der Ausrichtung und der Entkopplung, von der ersten Station (22) zur zweiten Station (24) verschoben wird.

7. Verfahren nach einem der Ansprüche 1 bis 3 mit den folgenden Vorausschritten:

- die Positionierung des Substrats (6) auf einem Träger (16, 30), selbst ohne Kontakt mit dem Heizelement (2),
- die Ausrichtung des zu hybridierenden Bauteils auf dem Substrat.

8. Verfahren nach Anspruch 7, mit außerdem einem Schritt des Hochhebens des Substrats (6), des zu hybridierenden Bauteils (4) und eventuell des beweglichen Trägers (16).

9. Verfahren nach Anspruch 8, wobei der Schritt des Hochhebens des Substrats, des zu hybridierenden Bauteils und eventuell des beweglichen Trägers nach dem Transport des durch das Substrat, das zu hybridierende Bauteil und eventuell den beweglichen Träger gebildeten Ganzen zu einer Hochheb- und Absenkstation (24) stattfindet.

10. Verfahren nach Anspruch 9, wobei die Herstellung des thermischen Kontakts des Substrats (6) mit dem Heizelement (2) durch die Verschiebung des Heizelements (2) zu der Hochheb- und Absenkstation und die Absenkung des durch das Bauteil, das Substrat und eventuell den beweglichen Träger (16) gebildete Ganze nach dem Temperaturanstieg des Heizelements (2) stattfindet.

11. Verfahren nach einem der Ansprüche 2, 5, 8, 9 oder 10, wobei das Hochheben und/oder Absenken mit Hilfe einer Glocke (28) stattfindet, in deren Innern eine kontrollierte Atmosphäre herrscht.

12. Verfahren nach einem der vorangehenden Ansprüche, mit - nach der Entkopplung des Substrats (6) und des Heizelements (2) - einem Schritt der Abkühlung des Substrats.

13. Verfahren nach Anspruch 12, wobei die Abkühlung durch Kontakt des Substrats (6) oder des beweglichen Trägers (16) mit einer Abkühlungsfläche (30) realisiert wird.

14. Verfahren nach den Ansprüchen 7 bis 13, wobei der Träger, auf dem das Substrat positioniert wird, durch die Abkühlungsfläche gebildet wird.

FIG. 1

FIG. 2A

FIG. 2B

FIG. 2C

FIG. 3

FIG. 4

FIG. 5A

FIG. 5B

FIG. 5 C

FIG. 5 D

FIG. 5 E

14

FIG. 6A

4   ↓ 22   28

16   6
2   30   20
18

FIG. 6B

28

30
20

FIG. 6C

28   ↓
2   30
18
20

FIG. 6D

28   ↓
30
18   20